# NEW EUROPEAN PATENT SPECIFICATION

(11) **EP 0 419 147 B2**
(45) Date of publication and mention of the opposition decision: **29.09.1999**
(45) Mention of the grant of the patent: 17.11.1994
(21) Application number: 90310075.8
(22) Date of filing: 14.09.1990
(51) Int. Cl.: G03F 7/004

(54) **Resist composition**
Schutzlack-Zusammensetzung
Composition formant réserve

(30) Priority: 20.09.1989 JP 24392589
(43) Date of publication of application: 27.03.1991
(73) Proprietor: NIPPON ZEON CO., LTD., Tokyo (JP)
(72) Inventor: Oie, Masayuki, Kamakura-shi, Kanagawa-ken (JP); Kawata, Shoji, Kawasaki-shi, Kanagawa-ken (JP); Yamada, Takamasa, Komaki-shi, Aichi-ken (JP)
(74) Representative: Hucker, Charlotte Jane

(56) References cited:
- EP-A- 0 164 248
- EP-A- 0 232 972
- EP-A- 0 307 918
- EP-A- 0 401 499
- DE-A- 2 914 558
- Römpps Chemie-Lexikon, 8th Ed.,1979, page 175, 2527 and 2528

## Description

### FIELD OF THE INVENTION

The present invention relates to a resist composition, and more specifically to a resist composition permitting formation of patterns by irradiation of far ultraviolet radiation, KrF excimer laser beams or the like. The resist composition according to this invention is suitable for use as a negative resist for minute processing of semiconductor elements.

### BACKGROUND OF THE INVENTION

Upon fabrication of a semiconductor device by minute processing making use of a resist, an image (pattern) is obtained by a lithography technique in which the resist is applied on the surface of a silicon wafer to form a photosensitive film, the film is exposed to light so as to form a latent image and the latent image is then developed to form a negative or positive image. After etching the silicon wafer using, as a protective film, the resist remaining on the silicon wafer, the resist film is removed, thereby completing the minute processing.

With the high integration, high density assembly and miniaturization of semiconductor elements toward IC, LSI and further VLSI, there has been a demand for a technique forming a minute pattern having a line width of 1 µm or less in recent years. It is however extremely difficult to form any minute patterns of 1 µm or less in line width with precision by the conventional lithography technique making use of near ultraviolet radiation or visible radiation. Their yields are also lowered to a significant extent.

Therefore, in order to enhance the resolution of exposure, there have been studied other lithography techniques making use of far ultraviolet radiation, KrF excimer laser beam (radiation having a wavelength of 248 nm, which is emitted by a krypton fluoride laser) or the like, which has a.shorter wavelength, instead of the conventional lithography technique utilizing light (ultraviolet radiation having a wavelength of 350-450 nm).

The resist material, which is central to such lithography techniques, is required to have a number of high properties. Among these properties, sensitivity, resolution, resistance to etching and storage stability are particularly important.

Namely, (1) the resist is required to have good sensitivity to radiations such as light and electron rays, which are used in exposure. The less the exposure dose required to make the resist sensitive, the better the sensitivity. (2) The resolution becomes higher as the minimum size processable using the resist is smaller. Therefore, the resist is required to be free from swell in any developers and to have high contrast. (3) The resist must be resistant to etching as a protective film. In particular, it is required to be resistant to dry etching making use of plasma or accelerated ions. (4) The resist is required to have good storage stability and undergo no decomposition and deterioration.

However, resist materials developed heretofore do not sufficiently satisfy the performance of all these properties. There has hence been a strong demand for enhancement of the performance of such properties.

For example, a negative resist such as polyglycidyl methacrylate is high in sensitivity, but poor in resolution and resistance to dry etching. On the other hand, a positive resist such as polymethyl methacrylate is good in resolution, but poor in sensitivity and resistance to dry etching.

Resists for minute processing, which are composed of a three component system of a base polymer, a photo-induced acid generator and an acid-sensitive substance, has recently been developed. These serve as a positive or negative resist by a reaction of the acid-sensitive substance in the presence of an acid as a catalyst, which has been generated by action of light, thereby changing the solubility and the like of the base polymer. For example, a negative resist composed of a novolak resin, methylol melamine and a photo-induced acid generator is known. Methylol melamine crosslinks the phenolic novolak resin in the presence of an acid as a catalyst, which has been generated by action of light, to insolubulize the novolak resin. In addition, there is also known a negative resist making use of a phenomenon in which a polymer such as a novolak-epoxy compound containing cation-polymerizing functional groups is exposed to light in the presence of a photo-induced acid generator to form a crosslinked structure by a reaction of the functional groups, thereby insolubilize the polymer.

However, when a photoresist of the novolak type is exposed to far ultraviolet radiation, the sensitivity and resolution of the photoresist become insufficient due to the fact that the resist itself absorbs the far ultraviolet radiation to a great extent, whereby a good minute pattern cannot be formed. Therefore, such resists are still insufficient in view of a recent higher standard of performance requirements.

In particular, EP-A-0232972 discloses negative photoresist compositions comprising an acid-hardening resin system and a halogenated organic photoacid-generating compound. EP-A-0307918 discloses a composition comprising a graft copolymer, a linear polymer, an epoxy resin and a polymerisation initiator capable of generating a Lewis acid by active energy irradiation.

EP-A-0401499 (published 12.12.90) discloses a resist composition comprising a partially-hydrogenated alkalisoluble phenolic resin, a compound capable of generating an acid on irradiation (a halogenated organic compound or an o-quinonedlazide) and a compound capable of cross-linking in the presence of acid, i.e. a compound containing a -C-O-R group, e.g. hexa(methoxymethylmelamine).

### SUMMARY OF THE INVENTION

According to the present invention, a resist composition comprises (A) a hydrogenated alkali-soluble phenolic resin, (B) a compound capable of generating an acid on irradiation, (C) a compound capable of cross-linking in the presence of the acid and a fluorine-containing surfactant. Compound (C) contains a -C-O-R group, R being as defined below.

The novel composition can have balanced sensitivity, resolution, resistance to etching and storage stability. It is suitable for use in lithography, when using short-wavelength UV radiation or KrF excimer lasers. It is suitable for use as a negative resist for minute processing of semiconductor elements.

### DETAILED DESCRIPTION OF THE INVENTION

Features of the present invention will hereinafter be described in detail.

### (Hydrogenated alkali-soluble phenolic resin)

In this invention, a hydrogenated alkali-soluble phenolic resin is used as a base polymer. The use of the hydrogenated phenolic resin results in a resist composition good in sensitivity, resolution, resistance to etching and storage stability.

The hydrogenated alkali-soluble phenolic resin is a resin obtained by hydrogenating, for example, an alkali-soluble phenolic resin such as a condensate of a phenol and an aldehyde, a condensate of a phenol and a ketone, a vinylphenolic polymer or an isopropenylphenolic polymer.

The hydrogenation is generally conducted so as to give a rate of hydrogenation in a range of 0.1-70%, preferably 1-50%. more preferably 3-40%. If the rate of hydrogenation should exceed 70%, the resulting hydrogenated phenolic resin will become insoluble in alkali. Such a highly-hydrogenated phenolic resin is hence unsuitable for use as a base polymer for a resist. On the other hand, if the rate of hydrogenation should be too low, the performance-enhancing effect owing to the hydrogenation will become less.

As specific examples of the phenol useful in the practice of this invention. may be mentioned phenol, cresol, xylenol, ethylphenol, phenylphenol, resorcinol, pyrocatechol, hydroquione, bisphenol A and pyrogallol.

As specific examples of the aldehyde, may be mentioned formaldehyde, acetoaldehyde, benzaldehyde and terephthalaldehyde.

As specific examples of the ketone, may be mentioned acetone, methyl ethyl ketone, diethyl ketone and diphenyl ketone.

The condensation reaction of their corresponding compounds mentioned above can be performed in accordance with a method known per se in the art.

The vinylphenolic polymer is selected from a homopolymer of vinylphenol and copolymers of vinylphenol and a component copolymerizable therewith.

As specific examples of the copolymerizable component, may be mentioned acrylic acid and derivatives thereof, methacrylic acid and derivatives thereof, styrene and derivatives thereof, maleic anhydride, vinyl acetate and acrylonitril.

The isopropenylphenolic polymer is selected from a homopolymer of isopropenylphenol and copolymers of isopropenylphenol and a component copolyrnerizable therewith.

As specific examples of the copolymerizable component, may be mentioned acrylic acid and derivatives thereof, methacrylic acid and derivatives thereof, styrene and derivatives thereof, maleic anhydride, vinyl acetate and acrylonitril.

The hydrogenation reaction of the phenolic resin can be performed by a method known per se in the art and Is achieved by dissolving the phenolic resin in an organic solvent and then introducing hydrogen into the solution in the present of a homogeneous or heterogeneous hydrogenation catalyst.

The concentration of the phenolic resin solution in the hydrogenation reaction Is 1-70 wt.%. preferably 1-40 wt.%. No particular limitation is imposed on the solvent so long as it does not adversely affect the hydrogenation catalyst and dissolves the phenolic resin.

No particular limitation is imposed on the hydrogenation catalyst so long as it is a metallic or nonmetallic catalyst having activity in the hydrogenation reaction. As specific examples of the catalyst. may be mentioned hydrogenation catalysts of the Fe, Co, Ni, Ru, Rh, Pd, Ir, Os, Pt, Or, Te, Mn, Ti, V, Zr, Mo and W types. These catalysts may be used either singly or in combination.

The reaction temperature in the hydrogenation reaction is generally 0-300°C, preferably 20-150°C. The reaction may be conducted at a temperature higher than 300°C. However, it is not preferable to perform the hydrogenation reaction at such a high temperature because side reaction tends to occur.

The pressure of hydrogen is an atmospheric pressure to 400 kg/cm², preferably 5 to 200 kg/cm².

After the hydrogenation reaction, the catalyst can be removed from the resin solution subjected to the hydrogenation reaction by reprecipitation, sedimentation, centrifugal separation, filtration or the like.

The hydrogenated alkali-soluble phenolic resins obtained in the above manner may be used either singly or in combination.

For example, a copolymer of styrene and acrylic acid, methacrylic acid or maleic anhydride, a copolymer of an alkene and maleic anhydride, a polymer of vinyl alcohol, a polymer of vinylpyrrolidone, rosin, shellac and/or the like may be optionally added to the resist composition according to this invention in order to improve its developability, storage stability, heat resistance, etc.

The amount of these optional components to be added is 0-50 parts by weight, preferably 5-20 parts by weight per 100 parts by weight of the hydrogenated alkali-soluble phenolic resin.

### (Compound cleavable upon exposure to active rays to form an acid)

No particular limitation is imposed on the compound cleavable upon exposure to active rays to form an acid (photo-induced acid generator) useful in the practice of this invention so long as it is a substance which generates a Brønsted acid or Lewis acid upon exposure to active rays. A variety of known compounds and mixtures may be used. As exemplary compounds and mixtures, may be mentioned onium salts, halogenated organic compounds, halogenated organic compound/organic metal mixtures and o-quinonediazide compounds.

As specific examples of the onium salts, may be mentioned diazonium salts, ammonium salts, iodonium salts, sulfonium salts, phosphonium salts, arsonium salts and oxonium salts.

As specific examples of the halogenated organic compounds, may be mentioned a variety of compounds such as haloalkyl-containing oxadiazole compounds described in U.S. Patent Nos. 4,212,970, 4,232,106, 4,279,982, Japanese Patent Application Laid-Open Nos. 3626/1985, 138539/1985, etc.; haloalkyl-containing triazine compounds described in U.S. Patent Nos. 3,954,475, 4,289,323, 4,239,850, 4,826,753, 4,837,128, Japanese Patent Application Laid-Open Nos. 175735/1987, 70243/1988, 298339/1988, 35548/1989, etc.; and haloalkyl-containing acetophenone compounds, haloalkyl-containing sulfoxide compounds, haloalkyl-containing sulfone compounds, haloalkyl-containing aliphatic hydrocarbon compounds, haloalkyl-containing aromatic hydrocarbon compounds, haloalkyl-containing heterocyclic compounds and sulfenyl halide compounds which are all described in Japanese Patent Publication No. 21601/1974.

As exemplary halogenated organic compounds, may be mentioned further halogen-containing compounds generally used as flame retardants, such as tris(β-chloroethyl) phosphate, tris(2,3-dichloropropyl) phosphate, tris(2,3-d ibromopropyl) phosphate, tris(2,3-dibromo-3-chloropropyl)phosphate, chlorotetrabromobutane, hexabromocyclododecane, hexabromobiphenyl, tribromophenyl allyl ether, tetrachlorobisphenol A, tetrabromobisphenol A, bis(bromoethyl ether) tetrabromobisphenol A, bis-(chloroethyl ether) tetrachlorobisphenol A, tris(2,3-dibromopropyl) isocyanurate, 2,2-bis(4-hydroxy-3,5-dibromophenyl)propane and 2,2-bis(4-hydroxye-thoxy-3,5-dibromophenyl)propane; and halogen-containing compounds generally used as organo-chloric pesticides, such as dichlorodiphenyltrichloroethane, benzene hexachloride, pentachlorophenol, 2,4,6-trichlorophenyl 4-nitrophenyl ether, 2,4-dichlorophenyl 3'-methoxy-4'-nitrophenyl ether, 2,4-dichlorophenoxyacetic acid, 4,5,6,7-tetrachlorophthalide, 1,1-bis(4-chlorophenyl)ethanol, 1,1,bis(4-chlorophenyl)-2,2,2-trichloroethanol, ethyl 4,4-dichlorobenzilate, 2,4,5,4'-tetrachlorodiphenyl sulfide and 2,4,5,4'-tetrachlorodiphenyl sulfone.

As specific examples of the o-quinonediazide compounds, may be mentioned 1,2-benzoquinonediazide-4-sulfonic acid ester, 1,2-naphthoquinonediazide-4-sulfonic acid ester, 1,2-naphthoquinonediazide-5-sulfonic acid ester, 2,1-naphthoquinonediazide-4-sulfonic acid ester, 2,1-naphthoquinonediazide-5-sulfonic acid ester and sulfonic acid esters of other quinonediazide derivatives; and 1,2-benzoquinonediazide-4-sulfonic acid chlorides 1,2-naphthoquinonediazide-4-sulfonic acid chlorides 1,2-naphthoquinonediazide-5-sulfonic acid chlorides 2,1-naphthoquinonediazide-4-sulfonic acid chlorides 2,1-naphthoquinonediazide-5-sulfonic acid chloride and sulfonic acid chlorides of other quinonediazide derivatives. These compounds may be used either singly or in combination.

The proportion of the compound cleavable upon exposure to active rays to form an acid is 0.1-50 parts by weight, preferably 1-30 parts by weight, more preferably 2-20 parts by weight per 100 parts by weight of the hydrogenated alkali-soluble phenolic resin. If the proportion should be lower than 0.1 part by weight, the formation of any patterns will become substantially impossible. On the other hand, if the proportion should exceed 50 parts by weight, the insolubilization of unexposed portions will tend to occur upon developing.

### (Acid-induced crosslinking compound)

### Compound containing C-O-R group(s)

Compound C (hereinafter called "acid-induced crosslinking compound") cross-links the hydrogenated phenolic resin in the presence of the acid derived from the compound cleavable upon exposure to active rays, to lower the solubility of the hydrogenated phenolic resin portions, which have been exposed to the active rays in an alkaline developer. R is alkyl or an epoxy group.

When R is alkyl, the acid-induced cross-linking compound is selected from alkyl-etherified melamine resins, alkyl-etherified benzoguanamine resins, alkyl-etherified urea resins and alkyl ether group-containing phenolic compounds.

The alkyl-etherified melamine resins can be synthesised in accordance with a method known per se ir the art and is described in detail in Ichiro Miwa and Hideo Matsunaga, "Urea-Melamine Resins", published by Nikkan Kogyo Shimbunsha (1979), and others. The alkyl-etherified melamine resins are obtained by alkyl etherifying methylolmelamine, which has been obtained by condensing melamine and formaldehyde under ba sic conditions, with an alcohol. As the alkyletherified melamine resins used in this invention, melamine resins comprising, as a main component, hexaalkyletherified melamine are preferred because they have good stor age stability. Among these, a hexamethyletherified melamine resin is particularly preferred.

The alkyletherified benzoguanamine resins can be synthesized with ease by using benzoguanamine in stead of melamine in the alkyletherified melamine resins. As the alkyletherified benzoguanamine resins used in this invention, tetraalkyletherified benzoguanamine resins are preferred because they have good storage stability. Among these, a tetramethyletherified benzoguanamine resin is particularly preferred.

The alkyletherified urea resins can be synthesized in accordance with a method known per se in the ar and is described in detail in the above-mentioned book entitled "Urea-Melamine Resins", and others. The al kyletherified urea resins are obtained by alkyletherifying methylolurea, which has been obtained by condens ing urea and formaldehyde, with an alcohol. As the alkyletherified urea resins used in this invention, alkyle therified products of monomethylolurea, dimethylolurea, trimethylolurea and urone compounds are preferred with the alkyletherified products of trimethylolurea being particularly preferred.

As specific examples of the alkyl ether group-containing phenolic compounds, may be mentioned compounds represented by the following general formula (I): 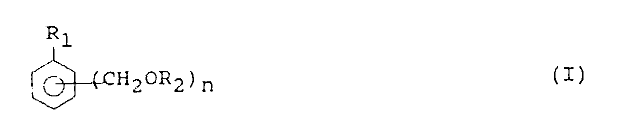 wherein R₁ means an alkyl, alkoxy, alkenyl or alkenyloxy group, R₂ denotes an alkyl group, and n stands fo an integer of 1-5, in particular, preferably 1-3.

When R is an epoxy group, the acid-induced cross-linking compound is selected from glycidyl ether epoxy resins such as bisphenol A epoxy, bisphenol F epoxy, bisphenol S epoxy, bisphenol E epoxy, novolak epoxy and brominated epoxy; alicyclic aliphatic epoxy resins containing cyclohexene oxide groups, tricyclodecene oxide groups, cyclopentene oxide groups or the like; glycidyl ester epoxy resins; glycidyl amine epoxy resins heterocyclic epoxy resins; and polyfunctional epoxy resins.

These epoxy resins can be synthesized in accordance with a method known per se in the art and is de scribed in detail in Hiroshi Kakiuchi, "Epoxy Resins", published by Shokodo (1985), and others.

These acid-induced crosslinking compounds may be used either singly or in combination. The proportion of the acid-induced crosslinking compound is 0.2-50 parts by weight, preferably 3-40 parts by weight, more preferably 5-30 parts by weight per 100 parts by weight of the hydrogenated alkali-soluble phenolic resin. If the proportion should be lower than 0.2 part by weight, the formation of any patterns will become substantially impossible. On the other hand, if the proportion should exceed 50 parts by weight, the insolubilization of un exposed portions will tend to occur upon developing.

### (Resist composition)

The resist composition according to this invention is generally used in a state that it is dissolved in a solvent In order to apply it on a substrate to form a resist film.

As exemplary solvents, may be mentioned ketones such as acetone, methyl ethyl ketone, cyclohexanone, cyclopentanone, cycloheptanone and butyrolactone; alcohols such as n-propyl alcohol, Isopropyl alcohol, n-butyl alcohol and t-butyl alcohol; ethers such as ethylene glycol dimethyl ether, ethylene glycol diethyl ether and dioxane; alcohol ethers such as ethylene glycol monomethyl ether, ethylene glycol monoethyl ether, propylene glycol monomethyl ether and propylene glycol monoethyl ether; esters such as propyl formate, butyl formate, propyl acetate, butyl acetate, methyl propionate, ethyl propionate, methyl butyrate and ethyl butyrate; monohydroxycarboxylates such as methyl 2-hydroxypropionate, ethyl 2-hydroxypropionate, methyl 2-methoxypropionate and ethyl 2-methoxypropionate; cellosolve esters such as cellosolve acetate, methylcellosolve acetate, ethylcellosolve acetate, propylcellosolve acetate and butylcellosolve acetate; propylene glycols such as propylene glycol, propylene glycol monomethyl ether, propylene glycol monomethyl ether acetate, propylene glycol monoethyl ether acetate and propylene glycol monobutyl ether, diethylene glycols such as diethylene glycol monomethyl ether, diethylene glycol monoethyl ether, diethylene glycol dimethyl ether, diethylene glycol diethyl ether and diethylene glycol methyl ethyl ether; halogenated hydrocarbons such as trichloroethylene; aromatic hydrocarbons such as toluene and xylene; and polar solvents such as dimethylacetamide, dimethylformamide, N-methylacetamide and N-methylpyrrolidone. These solvents may be used either singly or in combination.

In the resist composition of this invention, may be contained one or more of additives such as a surfactant, other than the fluorine-containing surfactant, storage stabilizer, sensitizer, anti-striation agent, plasticizer and anti-halation agent, as needed.

An aqueous solution of an alkali is used as a developer for the resist composition of this invention. As specific examples of the alkali, may be mentioned inorganic alkalis such as sodium hydroxide, potassium hydroxide, sodium silicate and ammonia; primary amines such as ethylamine and propylamine; secondary amines such as diethylamine and dipropylamine; tertiary amines such as trimethylamine and triethylamine; alcohol amines such as diethylethanolamine and triethanolamine; and quaternary ammonium salts such as tetramethylammonium hydroxide, tetraethylammonium hydroxide, trimethylhydroxymethylammonium hydroxide, triethylhydroxymethylammonium hydroxide and trimethylhydroxyethylammonium hydroxide.

If necessary, suitable amounts of a water-soluble organic solvent such as methanol, ethanol, propanol or ethylene glycol, a surfactant, a storage stabilizer, a dissolution inhibitor for the resin and/or the like may be added further to the aqueous alkali solution.

Using the resist composition of this invention. a resist film can be formed by applying its solution in a solvent on the surface of a substrate such as a silicon wafer by a method known per se in the art and then drying the solvent to remove it. As the coating method, spin coating can be recommended for use in particular.

The exposure of the resist composition can be conducted by exposing it to short-wavelength ultraviolet radiation or KrF excimer laser beam using a tar ultraviolet-irradiating apparatus or an excimer laser in which krypton and fluorine gases are sealed, thereby forming a minute pattern.

A heat treatment (post-exposure bake) after the exposure can accelerate the reaction of the acid with the acid-induced crosslinking compound (acid-catalyzed reaction) to further enhance the sensitivity of the resist composition.

### ADVANTAGES OF THE INVENTION

According to this invention, there is provided a resist composition in which sensitivity, resolution, resistance to etching, storage stability and the like are well balanced. The resist composition according to this invention Is a pattern-forming material suitable for use in lithography making use of short-wavelength radiation and is particularly suited for using as a negative resist for minute processing of semiconductor elements.

### EMBODIMENTS OF THE INVENTION

The present invention will hereinafter be described more specifically by Referential Examples. Examples and Comparative Example, incidentally, all designations of "part" or "parts" and "%" as will be used in the following examples mean part or parts by weight and wt.% unless otherwise provided.

### Referential Example 1:

### (Synthetic example of a hydrogenated phenolic resin)

An autoclave was charged with 50 g of m-cresol novolak (hereinafter abbreviated as "m-NVK") and 450 g of ethanol. The contents were sufficiently mixed to dissolve m-NVK. Thereafter, 6 g of Raney nickel as a hydrogenation catalyst was added, followed by purging of the system with nitrogen. The contents were then pressurized with hydrogen to 50 kg/cm² while maintaining them at 20°C and held for 30 minutes under the same pressure. The autoclave was then placed for 3 hours in a hot water bath of 50°C to hydrogenate m-NVK.

After the hydrogenation reaction, the Raney nickel was removed from the solution by filtration, and the reaction solution was poured in water to deposit a polymer. The thus-obtained polymer was dissolved in ethanol again. The resulting solution was poured in water to deposit the polymer. The polymer was then dissolved in dioxane, and the solution was lyophilized for 36 hours to obtain a dry polymer. Its yield was found to be 90%.

The thus-obtained polymer was found to have a weight-average molecular weight (Mw) of 6,000 and a rate of hydrogenation of 10% from results of the measurements of gel permeation chromatography (GPC) and nuclear magnetic resonance spectra (NMR), respectively. From the measurement of ultraviolet absorption (UV) spectra, it was observed that the transmittance of the hydrogenated m-NVK at 250 nm was increased about twice compared with that of the raw m-NVK.

### Referential Example 2:

### (Synthetic example of a hydrogenated phenolic resin)

A condensate of pyrogallol and acetone (hereinafter abbreviated as "PA") was treated under the same conditions as in Referential Example 1 to obtain a dry polymer. Its yield was found to be 90%.

The thus-obtained polymer was found to have an Mw of 4,000 and a rate of hydrogenation of 5% from results of the measurements of GPC and NMR, respectively. From the measurement of UV spectra, it was observed that the transmittance of the hydrogenated PA at 250 nm was increased about twice compared with that of the raw PA.

### Referential Example 3:

### (Synthetic example of a hydrogenated phenolic resin)

An autoclave was charged with 50 g of a vinylphenol polymer (hereinafter abbreviated as "PVP") and 450 g of ethanol. The contents were sufficiently mixed to dissolve PVP. Thereafter, 4 g of Raney nickel was added, followed by purging of the system with nitrogen. The contents were then pressurized with hydrogen to 50 kg/cm² while maintaining them at 20°C and held for 30 minutes under the same pressure. The autoclave was then placed for 5 hours in a hot water bath of 40°C to hydrogenate PVP.

After the hydrogenation reaction, the Raney nickel was removed from the solution by filtration, and the reaction solution was poured in water to deposit a polymer. The thus-obtained polymer was dissolved in ethanol again. The resulting solution was poured in water to deposit the polymer. The polymer was then dissolved in dioxane, and the solution was lyophilized for 40 hours to obtain a dry polymer. Its yield was found to be 95%.

The thus-obtained polymer was found to have an Mw of 8,000 and a rate of hydrogenation of 15% from results of the measurements of GPC and NMR, respectively. From the measurement of UV spectra, it was observed that the transmittance of the hydrogenated PVP at 250 nm was increased about twice compared with that of the raw PVP.

### Example 1:

In 300 parts of ethyl 2-methoxypropionate, were dissolved 100 parts of the hydrogenated m-NVK obtained in Referential Example 1, 2 parts of 2,4-bis(trichloromethyl)-6-phenyl-s-triazine as a photo-induced acid generator, 10 parts of an alkyletherified melamine resin ("NIKALAC MW-30", trade name; product of Sanwa Chemical Co., Ltd.) as an acid-induced crosslinking compound and 0.01 part of a fluorine-containing surfactant. The resulting solution was filtered through a polytetrafluoroethylene filter (manufactured by Millipore Company) having a pore size of 0.1 µm to prepare a resist solution.

After applying the resist solution by a spinner on a silicon wafer, the resist solution was baked for 90 seconds at 90°C, thereby forming a resist film having a thickness of 1.0 µm. The thus-formed resist film was exposed using a far ultraviolet-irradiating apparatus, "PLA-521FA" (manufactured by Canon Inc.) and a test mask. The thus-exposed film was then developed by immersion developing in an aqueous solution of tetramethylammonium hydroxide (concentration: 2.38%) as an aqueous alkali solution for 1 minute at 23°C, thereby obtaining a negative pattern.

The wafer on which the pattern had been formed was taken out of the aqueous alkali solution to observe it through an electron microscope. As a result, it was found that a pattern high in contrast was resolved. The film thickness of the pattern was measured by a thickness meter, "Alpha Step 200" (manufactured by Tenko Company) and was found to be 0.94 µm.

### Example 2:

Using a portion of the resist solution prepared in Example 1, the process up to the exposure was conducted in the same manner as in Example 1. Post-exposure bake was then effected for 60 seconds at 110°C, and the thus-baked film was developed by immersion developing in the aqueous solution of tetramethylammonium hydroxide for 1 minute at 23°C, thereby obtaining a negative pattern.

The wafer on which the pattern had been formed was taken out of the aqueous alkali solution to observe it through an electron microscope. As a result, it was found that a pattern having a line width of 0.50 µm was resolved. The film thickness of the pattern was measured by the thickness meters "Alpha Step 200" and was found to be 0.99 µm.

Using a dry etching apparatus, "DEM-ETIT" (manufactured by Nichiden Aneruba Company), the wafer on which the pattern had been formed was etched with a 30:10 mixed gas of CF₄ and H₂ at a power of 300 W, a pressure of 0.03 Torr and a frequency of 13.56 MHz. As a result, it was found that portions of the wafer, on which no pattern had been formed, are only etched and the resist composition according to this invention is hence excellent in resistance to etching.

### Example 3:

In 330 parts of ethyl 2-methoxypropionate, were dissolved 100 parts of the hydrogenated PA obtained in Referential Example 2, 3 parts of 2,4-bis(trichloromethyl)-6-phenyl-s-triazine as a photo-induced acid generator, 12 parts of an alkyletherified melamine resin ("NIKALAC MW-30") as an acid-induced crosslinking compound and 0.01 part of a fluorine-containing surfactant. The resulting solution was filtered through a polytetrafluoroethylene filter having a pore size of 0.1 µm to prepare a resist solution.

After applying the resist solution by a spinner on a silicon wafer, the resist solution was baked for 90 seconds at 85°C, thereby forming a resist film having a thickness of 1.0 µm. The thus-formed resist film was exposed using the far ultraviolet-irradiating apparatus, "PLA-521FA" and a test mask. Post-exposure bake was then effected for 60 seconds at 100°C, and the thus-baked film was developed by immersion developing in the aqueous solution of tetramethylammonium hydroxide for 1 minute at 23°C, thereby obtaining a negative pattern.

The wafer on which the pattern had been formed was taken out of the aqueous alkali solution to observe it through an electron microscope. As a result, it was found that a pattern high in contrast was resolved. The film thickness of the pattern was measured by the thickness meter, "Alpha Step 200" and was found to be 0.98 µm.

### Example 4:

In 330 parts of ethyl 2-methoxypropionate, were dissolved 100 parts of the hydrogenated PVP obtained in Referential Example 3, 3 parts of 2,4-bis(trichloromethyl)-6-phenyl-s-triazine as a photo-induced acid generator, 15 parts of an alkyletherified melamine resin ("NIKALAC MW-30") as an acid-induced crosslinking compound and 0.01 part of a fluorine-containing surfactant. The resulting solution was filtered through a polytetrafluoroethylene filter having a pore size of 0.1 µm to prepare a resist solution.

After applying the resist solution by a spinner on a silicon wafer, the resist solution was baked for 90 seconds at 90°C, thereby forming a resist film having a thickness of 1.0 µm. The thus-formed resist film was exposed using the far ultraviolet-irradiating apparatus, "PLA-521FA" and a test mask. Post-exposure bake was then effected for 60 seconds at 110°C, and the thus-baked film was developed by immersion developing in the aqueous solution of tetramethylammonium hydroxide for 1 minute at 23°C, thereby obtaining a negative pattern.

The wafer on which the pattern had been formed was taken out of the aqueous alkali solution to observe it through an electron microscope. As a result, it was found that a pattern having a line width of 0.50 µm was resolved. The film thickness of the pattern was measured by the thickness meter, "Alpha Step 200" and was found to be 0.96 µm.

### Example 5:

In 330 parts of cyclohexanone, were dissolved 100 parts of the hydrogenated PVP obtained in Referential Example 3, 2 parts of 4,4'-di-t-butyldiphenyliodonium fluorophosphate as a photo-induced acid generator, 15 parts of an alkyletherified benzoguanamine resin ("NIKALAC BL-60", trade name; product of Sanwa Chemical Co., Ltd.) as an acid-induced crosslinking compound and 0.01 part of a fluorine-containing surfactant. The resulting solution was filtered through a polytetrafluoroethylene filter having a pore size of 0.1 µm to prepare a resist solution.

After applying the resist solution by a spinner on a silicon wafer, the resist solution was baked for 90 seconds at 90°C, thereby forming a resist film having a thickness of 1.0 µm. The thus-formed resist film was exposed using an excimer laser, "C2926" (manufactured by Hamamatsu Photonics K.K.), in which krypton and fluorine gases are sealed, and a test mask. Post-exposure bake was then effected for 60 seconds at 100°C, and the thus-baked film was developed by immersion developing in the aqueous solution of tetramethylammonium hydroxide for 1 minute at 23°C, thereby obtaining a negative pattern.

The wafer on which the pattern had been formed was taken out of the aqueous alkali solution to observe it through an electron microscope. As a result, it was found that a pattern high in contrast was resolved. The film thickness of the pattern was measured by the thickness meter, "Alpha Step 200" and was found to be 0.99 µm.

### Example 6:

In 330 parts of cyclohexanone, were dissolved 100 parts of the hydrogenated m-NVK obtained in Referential Example 1,2 parts of tribromomethyl-p-chlorophenyl sulfone as a photo-induced acid generator, 15 parts of an alkyletherified urea resin, which had been synthesized in accordance with a method known per se in the art, as an acid-induced crosslinking compound and 0.01 part of a fluorine-containing surfactant. The resulting solution was filtered through a polytetrafluoroethylene filter having a pore size of 0.1 µm to prepare a resist solution.

After applying the resist solution by a spinner on a silicon wafer, the resist solution was baked for 90 seconds at 90°C, thereby forming a resist film having a thickness of 1.0 µm. The thus-formed resist film was exposed using the far ultraviolet-irradiating apparatus, "PLA-521FA" and a test mask. Post-exposure bake was then effected for 60 seconds at 110°C, and the thus-baked film was developed by immersion developing in the aqueous solution of tetramethylammonium hydroxide for 1 minute at 23°C, thereby obtaining a negative pattern.

The wafer on which the pattern had been formed was taken out of the aqueous alkali solution to observe it through an electron microscope. As a result, it was found that a pattern having a line width of 0.50 µm was resolved. The film thickness of the pattern was measured by the thickness meter, "Alpha Step 200" and was found to be 0.96 µm.

### Example 7:

In 330 parts of ethyl 2-methoxypropionate, were dissolved 100 parts of the hydrogenated m-NVK obtained in Referential Example 1, 12 parts of 1,2-naphthoquinonediazide-4-sulfonyl chloride as a photo-induced acid generator, 15 parts of an alkyletherified melamine resin ("NIKALAC MW-30") as an acid-induced crosslinking compound and 0.01 part of a fluorine-containing surfactant. The resulting solution was filtered through a polytetrafluoroethylene filter having a pore size of 0.1 µm to prepare a resist solution.

After applying the resist solution by a spinner on a silicon wafer, the resist solution was baked for 90 seconds at 90°C, thereby forming a resist film having a thickness of 1.0 µm. The thus-formed resist film was exposed using the far ultraviolet-irradiating apparatus, "PLA-521FA" and a test mask. Post-exposure bake was then effected for 60 seconds at 110°C, and the thus-baked film was developed by immersion developing in the aqueous solution of tetramethylammonium hydroxide for 1 minute at 23°C, thereby obtaining a negative pattern.

The wafer on which the pattern had been formed was taken out of the aqueous alkali solution to observe it through an electron microscope. As a result, it was found that a pattern high in contrast was resolved. The film thickness of the pattern was measured by the thickness meter, "Alpha Step 200" and was found to be 0.98 µm.

### Example 8:

In 330 parts of ethyl 2-methoxypropionate, were dissolved 100 parts of the hydrogenated PVP obtained in Referential Example 3, 12 parts of 1,2-naphthoquinonediazide-4-sulfonyl chloride as a photo-induced acid generator, 15 parts of a methyletherified product of an alkylether group-containing phenolic compound ("Methylon RESIN75108", trade name; product of General Electric Co.) as an acid-induced crosslinking compound and 0.01 part of a fluorine-containing surfactant. The resulting solution was filtered through a polytetrafluoroethylene filter having a pore size of 0.1 µm to prepare a resist solution.

After applying the resist solution by a spinner on a silicon wafer, the resist solution was baked for 90 seconds at 85°C, thereby forming a resist film having a thickness of 1.0 µm. The thus-formed resist film was exposed using the excimer laser, "C2926" (manufactured by Hamamatsu Photonics K.K.), in which krypton and fluonne gases are sealed, and a test mask. Post-exposure bake was then effected for 90 seconds at 110°C, and the thus-baked film was developed by immersion developing in the aqueous solution of tetramethylammonium hydroxide for 1 minute at 23°C, thereby obtaining a negative pattern.

The wafer on which the pattern had been formed was taken out of the aqueous alkali solution to observe it through an electron microscope. As a result, it was found that a pattern high in contrast was resolved. The film thickness of the pattern was measured by the thickness meter, "Alpha Step 200" and was found to be 0.99 µm.

### Example 9:

In 330 parts of ethyl 2-methoxypropionate, were dissolved 100 parts of the hydrogenated PVP obtained in Referential Example 3, 3 parts of 4,4'-di-t-butyldiphenyliodonium fluorophosphate as a photo-induced acid generator, 10 parts of a bisphenol A epoxy resin as an acid-induced crosslinking compound and 0.01 part of a fluorine-containing surfactant. The resulting solution was filtered through a polytetrafluoroethylene filter having a pore size of 0.1 µm to prepare a resist solution.

After applying the resist solution by a spinner on a silicon wafer, the resist solution was baked for 90 seconds at 90°C, thereby forming a resist film having a thickness of 1.0 µm. The thus-formed resist film was exposed using the far ultraviolet-irradiating apparatus, "PLA-521FA" and a test mask. Post-exposure bake was then effected for 60 seconds at 110°C, and the thus-baked film was developed by immersion developing in the aqueous solution of tetramethylammonium hydroxide for 1 minute at 23°C, thereby obtaining a negative pattern. The film thickness of the pattern was measured by the thickness meter, "Alpha Step 200" and was found to be 0.98 µm.

### Comparative Example 1:

In 300 parts of ethyl 2-methoxypropionate, were dissolved 100 parts of unhydrogenated m-NVK, 2 parts of 2,4-bis(trichloromethyl)-6-phenyl-s-triazine as a photo-induced acid generator, 10 parts of an alkyletherified melamine resin ("NIKALAC MW-30") as an acid-induced crosslinking compound and 0.01 part of a fluorine-containing surfactant. The resulting solution was filtered through a polytetrafluoroethylene filter (manufactured by Millipore Company) having a pore size of 0.1 µm to prepare a resist solution.

The thus-prepared resist solution was evaluated in the same manner as in Example 2. As a result, it was observed that a pattern having a line width of 0.50 µm was not resolved and the sensitivity of the resist in this comparative example was lower than that of the resist in Example 2.

## Claims

1. A resist composition comprising:
(A) a hydrogenated alkali-soluble phenolic resin;
(B) a compound capable of generating an acid on irradiation; and
(C) a compound capable of cross-linking in the presence of the acid and which contains a C-O-R group, characterised in that either R is alkyl and the compound (C) is selected from alkyl-etherified melamine resins, alkyl-etherified benzoguanamine resins, alkyl-etherified urea resins and alkyl ether group-containing phenolic compounds, or R is an epoxy group and the compound (C) is selected from glycidyl ether epoxy resins, alicyclic aliphatic epoxy resins, glycidyl ester epoxy resins, glycidyl amine epoxy resins, heterocyclic epoxy resins and polyfunctional epoxy resins; and (D) a fluorine-containing surfactant.

2. A composition as claimed in claim 1, wherein the resin is a phenol-aldehyde condensate, a phenol-ketone condensate, a vinylphenolic polymer or an isopropylphenolic polymer.

3. A composition as claimed in claim 1 or claim 2, wherein the degree of hydrogenation of the resin (A) is 0.1-70%.

4. A composition as claimed in any preceding claim, wherein the acid is a Brønsted or Lewis acid.

5. A composition as claimed in any preceding claim, wherein the compound (B) is an onium salt, a halogenated organic compound, a halogenated organic compound/organic metal mixture or an o-quinonediazide compound.

6. A composition as claimed in any preceding claim, which comprises 0.1-50 parts by weight of the compound (B) per 100 parts by weight of the resin (A).

7. A composition as claimed in any preceding claim, which comprises 0.2-50 parts by weight of the compound (C) per 100 parts by weight of the resin (A).

8. Use of a composition as claimed in any preceding claim, as a negative resist in the processing of semiconductor elements.

## Patentansprüche

1. Resist-Zusammensetzung umfassend:
(A) ein hydriertes alkalilösliches Phenolharz;
(B) eine Verbindung, die fähig ist, beim Bestrahlen eine Säure zu erzeugen;
(C) eine Verbindung, die fähig ist, in Gegenwart der Säure zu vernetzen, und die eine C-O-R Gruppe enthält, dadurch gekennzeichnet, daß entweder R Alkyl ist und die Verbindung (C) ausgewählt ist aus alkylveretherten Melaminharzen, alkylveretherten Benzoguanaminharzen, alkylveretherten Harnstoffharzen und Alkylethergruppen enthaltenden Phenolverbindungen, oder R eine Epoxygruppe ist und die Verbindung (C) ausgewählt ist aus Glycidylether-Epoxyharzen, alicyclischen, aliphatischen Epoxyharzen, Glycidylester-Epoxyharzen, Glycidylamin-Epoxyharzen, heterocyclischen Epoxyharzen und polyfunktionellen Epoxyharzen; und
(D) ein Fluor enthaltendes Tensid.

2. Zusammensetzung nach Anspruch 1, worin das Harz ein Phenol-Aldehyd-Kondensat, ein Phenol-Keton-Kondensat, ein Vinylphenol-Polymer oder ein Isopropylphenol-Polymer ist.

3. Zusammensetzung nach Anspruch 1 oder Anspruch 2, worin der Hydrierungsgrad des Harzes (A) 0,1-70% beträgt.

4. Zusammensetzung nach irgendeinem vorangehenden Anspruch, worin die Säure eine Brönsted- oder Lewis-Säure ist.

5. Zusammensetzung nach irgendeinem vorangehenden Anspruch, worin die Verbindung (B) ein Oniumsalz, eine halogenierte organische Verbindung, eine halogenierte organische Verbindung/Organometall-Mischung oder eine o-Chinondiazid-Verbindung ist.

6. Zusammensetzung nach irgendeinem vorangehenden Anspruch, welche 0,1-50 Gewichtsteile der Verbindung (B) pro 100 Gewichtsteile des Harzes (A) umfaßt.

7. Zusammensetzung nach irgendeinem vorangehenden Anspruch, welche 0,2-50 Gewichtsteile der Verbindung (C) pro 100 Gewichtsteile des Harzes (A) umfaßt.

8. Verwendung einer Zusammensetzung nach irgendeinem vorangehenden Anspruch als Negativresist bei der Verarbeitung von Halbleiterelementen.

## Revendications

1. Composition formant réserve comprenant:
(A) une résine phénolique soluble dans les alcalis hydrogènée;
(B) un composé capable de générer un acide lors d'une irradiation; et
(C) un composé capable de réticulation en présence de l'acide et qui contient un groupe C-O-R, caractérisée en ce que soit R est alkyle et le composé (C) est sélectionné parmi des résines mélamines éthérifiées-alkyle, des résines de benzoguanamine éthérifiées-alkyle, des résines urées éthérifiées-alkyle et des composés phénoliques contenant un groupe alkyl éther ou bien R est un groupe époxy et le composé (C) est sélectionné parmi des résines époxy glycicyl éther, des résines époxy aliphatiques aliphatiques, des résines époxy glycidyl ester, des résines époxy glycidyl amine, des résines époxy hétérocycliques et des résines époxy polyfonctionnelles; et (D) un agent tensio-actif contenant du fluor.

2. Composition selon la revendication 1 où la résine est un condensat de phénol-aldéhyde, un condensat de phénol-cètone, un polymère vinylphénolique ou un polymère isopropylphénolique.

3. Composition selon la revendication 1 ou la revendication 2 où le degré d'hydrogénation de la résine (A) est de 0,1 à 70%.

4. Composition selon l'une quelconque des revendications précédentes, où l'acide est un acide de Brønsted ou de Lewis.

5. Composition selon l'une des revendications précédentes où le composé (B) est un sel d'onium, un composé organique halogéné, un composé organique halogéné/mélange de métaux organiques Ou un composé de o-quinonediazide.

6. Composition selon l'une quelconque des revendications précédentes, qui comprend 0,1-50 parties en poids du composé (B) pour 100 parties en poids de la résine (A).

7. Composition selon l'une quelconque des revendications précédentes, qui comprend 0,2-50 parties en poids du composé (C) pour 100 parties en poids de la résine (A).

8. Utilisation d'une composition selon l'une quelconque des revendications précédentes en tant que réserve négative dans le traitement d'éléments semiconducteurs.
